Europäisches Patentamt

European Patent Office

Office européen des brevets

(19)

(11) Veröffentlichungsnummer: **0 014 744**
**B1**

(12) **EUROPÄISCHE PATENTSCHRIFT**

(45) Veröffentlichungstag der Patentschrift:
08.12.82

(21) Anmeldenummer: 79104632.9

(22) Anmeldetag: 21.11.79

(51) Int. Cl.³: **H 01 L 41/22,** H 01 L 41/04,
G 01 L 1/16, G 01 L 9/08,
G 01 P 15/08

(54) Verfahren zum Herstellen eines piezoelektrischen Wandlerelementes.

(30) Priorität: 20.02.79 DE 2906451

(43) Veröffentlichungstag der Anmeldung:
03.09.80 Patentblatt 80/18

(45) Bekanntmachung des Hinweises auf die Patenterteilung:
08.12.82 Patentblatt 82/49

(84) Benannte Vertragsstaaten:
AT CH DE FR GB

(56) Entgegenhaltungen:
GB-A-901 195
US-A-3 858 065

(73) Patentinhaber: Kistler Instrumente AG,
Eulachstrasse 22, CH-8408 Winterthur (CH)

(72) Erfinder: Boltshauser, Werner, Seenerstrasse 184,
CH-8405 Winterthur (CH)
Erfinder: Sonderegger, Hans-Conrad, Dipl.-Ing.,
Sonnhaldenstrasse 7, CH-8413 Neftenbach (CH)

(74) Vertreter: Schmidt, Horst, Dr. et al, Patentanwälte
Pohlmann & Schmidt Siegfriedstrasse 8,
D-8000 München 40 (DE)

## Verfahren zum Herstellen eines piezoelektrischen Wandlerelementes

Die Erfindung betrifft ein Verfahren zum Herstellen eines piezoelektrischen Wandlerelementes, insbesondere zum Einbau in Druck-, Kraft- oder Beschleunigungsaufnehmern, bestehend aus einem Befestigungsteil und wenigstens einem durch einen außen umgreifenden Schrumpfring auf das Befestigungsteil aufgeschrumpften Ringscherelement aus piezoelektrischem Material mit einem offenen Längsschlitz.

In der Meßtechnik werden Meßwertaufnehmer mit piezoelektrischen Wandlerelementen zur Erfassung von mechanischen Größen, wie Schwingungen, Kräften und Drücken, seit Jahrzehnten erfolgreich eingesetzt. Die Wandlerelemente sind dabei in vollständig abgeschlossenen Beschleunigungs-, Schwingungs-, Kraft- und Druckaufnehmergehäusen eingebaut, die mit entsprechenden Befestigungsteilen, Krafteinleitungsflächen und Druckbeaufschlagungsmembranen versehen sind sowie Anschlüsse zur Abnahme des Meßsignales aufweisen. Je nach Verwendungszweck können sie daher ganz verschiedene äußere Formen haben. Von Bedeutung ist aber, daß das Wandlerelement in allen Fällen die Aufgabe hat, eine mechanische Kraft in ein proportionales elektrisches Signal umzusetzen. Dabei wurden insbesondere für die Beschleunigungs- und Schwingungsmessung schon Wandler eingesetzt, die nach dem Schub- oder Scherprinzip arbeiten. Versuche, ein Einheitswandlerelement zu schaffen, das sich zum Einbau in sämtliche vorgenannten Meßwertaufnehmer zur Erfassung unterschiedlicher mechanischer Größen verwenden läßt, sind bislang jedoch gescheitert. Insbesondere ist kein universelles Piezowandlerelement bekannt geworden, das sich leicht in Serie herstellen läßt und für alle erwähnten Bauarten von Meßwertaufnehmern ohne große Anpassungsarbeiten verwendbar ist.

So wird in der DE-OS 2 817 981 ein Beschleunigungsaufnehmer mit drei auf Scherung beanspruchten rechteckförmigen Piezoplatten beschrieben, die über drei genau abgestimmte Segmentplatten mittels eines Federringes auf einem dreieckförmig bearbeiteten Befestigungsteil aufgeklemmt sind. Diese Konstruktion ist äußerst aufwendig, sowohl in der Herstellung der Teile wie auch in deren Montage. Aber auch das in der genannten Druckschrift weiter beschriebene Herstellungsverfahren bringt keine wesentliche Vereinfachung, da das hierfür notwendige Anbringen von hochpräzisen Schlitzen in einer Vorform des Befestigungsteils für die Aufnahme der Piezoplatten mit komplizierten Säge- und/oder Fräsarbeiten verbunden ist und in der Praxis mit der gewünschten Genaugkeit in der Regel nicht gelingt. Zudem bedingt das Verfahren, daß das Befestigungsteil und die daraus entwickelten Klemmsegmente notwendigerweise aus dem gleichen Material bestehen, was insbesondere für piezoelektrische Beschleunigungsaufnehmer nachteilig ist, da die Klemmsegmente vorteilhafterweise aus einem Schwermetall gebildet sein sollten.

Eine weitere Anordnung eines auf Scherung beanspruchten piezoelektrischen Wandlerelementes für die Beschleunigungsmessung wird in der DE-OS 2 700 342 beschrieben. Hier wird ein keramisches Piezoelement in Form eines konischen Ringes mittels einer Axialschraube und eines Klemmkonus auf einen konischen Zapfen aufgeklemmt. Durch die zweidimensionale Verklemmung des keramischen Piezoelementes wird dessen Funktion jedoch erheblich beeinträchtigt, was sich in einer übermäßigen Unlinearität und stark vergrößerten Hysterese auswirkt. Für genaue phasentreue Beschleunigungs- und Schwingungsmessungen können solche Aufnehmer daher nicht eingesetzt werden.

Aus der US-PS 3 858 065 ist ferner ein piezoelektrisches Wandlerelement für Beschleunigungsmessungen bekannt, das einen zentralen zylindrischen Befestigungsteil, ein diesen konzentrisch umgebendes zylindrisches Ringscherelement und einen das Ringscherelement konzentrisch umgebenden eine träge Masse darstellenden Ring aufweist. Das Ringscherelement ist mittels einer leitfähigen Kitt- oder Lötverbindung an dem Befestigungsteil einerseits und an dem Massenring andererseits befestigt. Solche leitfähigen Kitt- oder Lötverbindungen können bekanntlich nur für begrenzte Temperaturbereiche und für begrenzte mechanische Beanspruchungen verwendet werden, so daß derartig aufgebaute Wandlerelemente in ihrer Anwendungsvielfalt stark eingeschränkt sind. Zudem erzeugen solche teilweise elastischen Kitt- oder Lötzwischenschichten vermehrt Hysterese und Unlinearitäten sowie je nach Art des verwendeten Kittes beim Trocknen eine über die Zylinderfläche ungleichmäßig verteilte Schrumpfspannung, die eine ungleichmäßige Schubbeanspruchung durch die Massenkräfte bedingt.

Die aufgezeigten bekannten Lösungsvorschläge sind deshalb nicht geeignet, ein universell verwendbares Wandlerelement vorzusehen, das in weiten Beanspruchungs- und Temperaturbereichen genaue und zuverlässige Messungen ermöglicht.

Um wenigstens teilweise die mit den bekannten Wandlerelementen verbundenen Nachteile zu beheben, wird weiter in der US-Patentschrift 3 725 986 vorgeschlagen, das piezoelektrische Ringscherelement mittels eines außen umgelegten Schrumpfringes auf ein zentrales Befestigungsteil aufzuschrumpfen, so daß keine Kitt- oder Lötverbindungen vorliegen. Um im Ringscherelement einen im wesentlichen nur einachsigen radialen Vorspannungszustand zu erhalten, weist das Ringscherelement weiter einen offenen Längsschlitz auf, der das Auftreten von ansonsten beim Schrumpfvorgang zusätzlich entstehenden Umfangsspannungen verhindert. Obschon mit einer solchen Ausbildung des Wandlerelementes zahlreiche der vorgenannten Probleme beseitigt sind, haben Versuche gezeigt, daß die mit der Anwendung der Schrumpftechnik verbundenen hohen thermischen und mechanischen Belastungen des Ringscherelementes leicht zu Rissen in den dafür verwendeten Einkristallen führen und/oder lokale Umpolarisierungen, insbesondere bei Verwendung einer Piezokeramik, zur Folge haben. Diese Störungen können sich in mehr oder minder starkem Umfang meßwertverfälschend auswirken. Um die Rißbildung bzw. lokale Umpolarisierung möglichst klein zu halten, ist daher bei der Herstellung des bekannten Wandlerelementes besondere Sorgfalt einzuhalten, was ein erstliches Problem für die gewünschte Serienfertigung darstellt.

Zur Beseitigung der vorerwähnten Nachteile wird demgegenüber ausgehend von einem Verfahren zum Herstellen eines piezoelektrischen Wandlerelementes der im Oberbegriff des Anspruchs 1 genannten und aus der US-PS 3 725 986 bekannten Art vorgeschlagen, daß das Ringscherelement zunächst mittels eines darum gelegten ebenfalls geschlitzten Montageringes an dem Befestigungsteil vorfixiert wird und dann in an sich bekannter Weise mittels des außen um den Montagering gelegten erhitzten Schrumpfringes bei dessen Abkühlung fest auf das Befestigungsteil aufgeschrumpft wird, wobei der Montagering eine Überhitzung des Ringscherelementes beim Schrumpfvorgang verhindert.

Die Verwendung des geschlitzten Montageringes hat nicht nur den Vorteil, daß beim Schrumpfvorgang verhindert wird, daß das Ringscherelement schockartig der Wärme des Schrumpfringes mit den beschriebenen Auswirkungen ausgesetzt wird, sondern erleichtert darüberhinaus auch den Herstellungsvorgang selbst erheblich, indem mit einfachen Mitteln eine präzise Vorfixierung des Ringscherelementes an dem Befestigungsteil vorgenommen werden kann. Das erfindungsgemäß hergestellte Wandlerelement beinhaltet somit sämtliche mit der Verwendung der Schrumpftechnik verbundene Vorteile, ohne jedoch die dabei in der Regel auftretenden Nachteile, wie Rißbildung und lokale Umpolarisierungen im Piezomaterial infolge von Überhitzung, Probleme bei der Serienfertigung und dgl., aufzuweisen.

Eine besonders bevorzugte Weiterbildung der Erfindung zeichnet sich dadurch aus, daß der geschlitzte Montagering einstückiges Teil einer Montagezange ist, die nach der Abkühlung vom Montagering abgetrennt wird. Beim Schrumpfvorgang stellt die Montagezange ein zusätzliches Bauteil mit Wärmeaufnahmekapazität dar, in das der überwiegende Teil der beim Schrumpfvorgang auftretenden Wärmeschockwelle direkt abgeleitet wird.

Andere Weiterbildungen der Erfindung sind in den Unteransprüchen aufgeführt.

Zusammengefaßt verwendet das erfindungsgemäße Wandlerelement ein ringförmiges Scherelement, gebildet aus einem Hohlzylinder aus piezoelektrischem Einkristall- oder Keramikmaterial, der in Längsrichtung wenigstens einen offenen Schlitz aufweist. Die Bearbeitung des Innen- und Außendurchmessers des Ringscherelementes geschieht vorzugsweise am starren Hohlzylinder vor dem Anbringen des Längsschlitzes. Anschließend wird das Element in der Tiefe seiner Wanddicke in Längsrichtung geschlitzt und erhält so in radialer Richtung eine gewisse Elastizität. Der Innendurchmesser des Ringscherelementes sowie der Außendurchmesser des das Element aufnehmenden Befestigungsteils sind so bemessen, daß sich das Ringscherelement mit leichtem Haftsitz auf das Befestigungsteil aufschieben läßt. Anschließend wird der Montagering um das Ringscherelement gelegt und dann auf den Montagering der erhitzte Schrumpfring aufgesetzt, so daß sich nach Abkühlung des Schrumpfringes im Ringscherelement ein im wesentlichen nur einachsiger Radialspannungszustand einstellt, der homogen über die ganze Zylinderoberfläche des Ringscherelementes verteilt ist. Durch optimale Gestaltung von Ringscherelement, Schrumpfring und Befestigungsteil bezüglich der Materialwahl und Dimensionierung können sehr hohe Schubkräfte auch bei hohen Temperaturen übertragen werden. Der einachsige homogene Spannungszustand im Ringscherelement in Verbindung mit der frei von Rissen und lokalen Umpolarisierungen verbleibenden Kristallstruktur gewährleistet eine lineare, hysteresefreie und symmetrische Kraftumsetzung in beiden Axialrichtungen. Das so gebildete Wandlerelement kann nicht nur serienmäßig mit der gewünschten Präzision ohne Schwierigkeiten hergestellt werden, sondern läßt sich auch leicht an die betreffenden Anforderungen unterschiedlicher Meßwertaufnehmer anpassen.

Die Erfindung wird nachfolgend anhand von Ausführungsbeispielen und der Zeichnung näher erläutert. Es zeigt

Fig. 1 eine längsgeschnittene Ansicht von einem erfindungsgemäß hergestellten piezoelektrischen Wandlerelement,

Fig. 2 einen Schnitt längs der Schnittlinie 2-2 in Fig. 1,

Fig. 3 eine perspektivische Ansicht von zwei zusammengekitteten Einkristallsegmenten zum Vorsehen des Ringscherelementes für das Wandlerelement nach Fig. 1,

Fig. 4 eine längsgeschnittene Ansicht von einem erfindungsgemäß aufgebauten Wandlerelement für einen Beschleunigungsaufnehmer mit einer auf einen Kalibrierprüfstand direkt justierbaren Zusatzmasse.

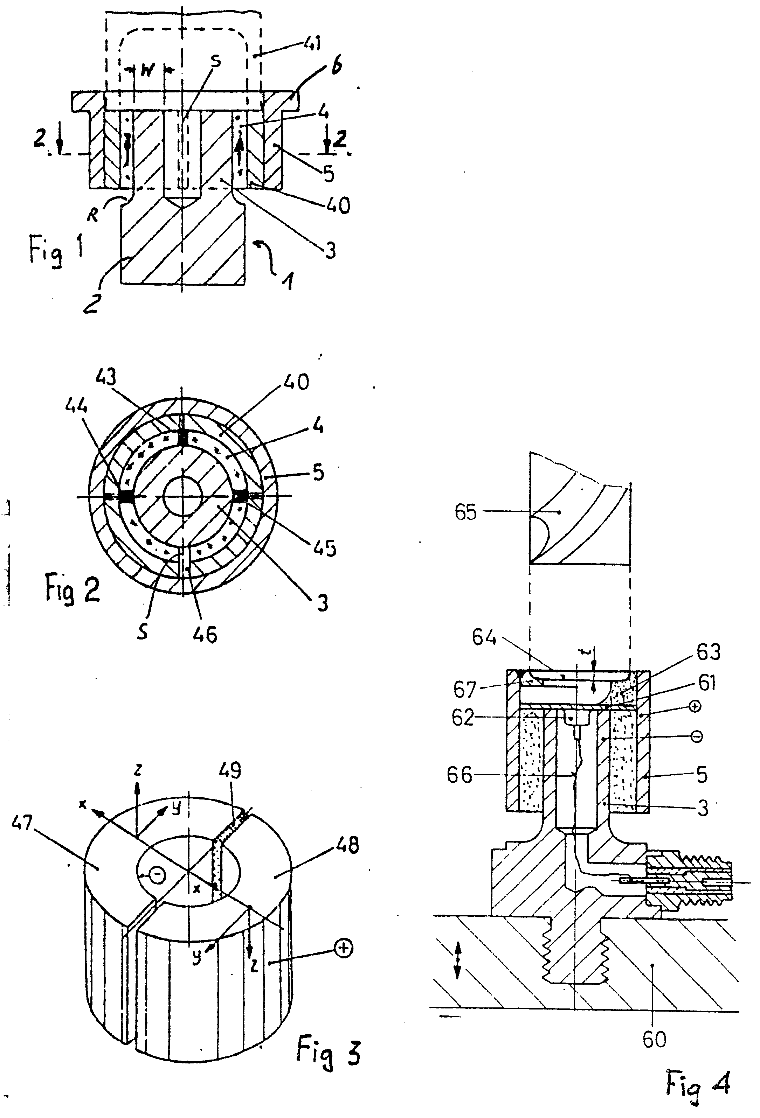

Nach Fig. 1 besteht das erfindungsgemäße Wandlerelement aus einem allgemein mit 1 bezeichneten Befestigungsteil, das einen Paßkolben 2 und einen daran koaxial angeformten rohrförmigen Ansatz 3 umfaßt. Vorzugsweise ist der Durchmesser des Paßkolbens 2 größer als der Durchmesser des rohrförmigen Ansatzes 3, wobei der Übergang zwischen den beiden Abschnitten um einen Radius R ausgerundet ist. Ein Ringscherelement 4, das aus einem Einkristallmaterial oder einer Piezokeramik bestehen kann, ist in seiner Längsachse, wie mit Pfeilen angedeutet, ansprechempfindlich bzw. polarisiert und weist einen Längsschlitz S auf, vgl. auch Fig. 2. Das Bezugszeichen 5 betrifft einen Schrumpfring und das Bezugszeichen 40 einen zwischen Schrumpfring und Ringscherelement angeordneten geschlitzten Montagering, worauf nachfolgend noch näher eingegangen wird. Der Schrumpfring 5 hat einen an seinem einen Endbereich angeformten, nach außen weisenden Ringflansch 6. Nach Aufschrumpfen des Schrumpfringes 5 auf die vormontierte Anordnung, bestehend aus Befestigungsteil 1, Ringscherelement 4 und Montagering 40, entsteht eine festmontierte Einheit mit eindimensionaler, radial gerichteter, hoher Verspannung, die durch Reibung große Schubkräfte übertragen kann. Das so gebildete Wandlerelement läßt sich in Meßwertaufnehmer für verschiedene Erfassungszwecke einsetzen.

Durch den Längsschlitz S ist das Ringscherelement radial voll elastisch und entsteht durch den Schrumpfvorgang in ihm ein eindeutig nur radial gerichteter Spannungszustand. Der vom Schrumpfring 5 auf das Ringscherelement 4 übertragenen Radialspannung entspricht eine Radialspannung entgegengesetzt gleicher Größe, die vom rohrförmigen Ansatz 3 aus einwirkt. Es ergibt sich somit eine im wesentlichen gleichmäßige Radialspannungsverteilung über den gesamten Querschnitt des hohlzylinderförmigen Ringscherelementes 4. Bei Temperaturänderungen ändert sich infolge der unterschiedlichen Ausdehnungskoeffizienten der verwendeten Materialien nur der Betrag der Radialspannung. Die homogene Spannungsverteilung im Ringscherelement bleibt jedoch voll erhalten, was für die piezoelektrische Verhaltensweise der Piezomaterialien von besonderer Bedeutung ist, da sich bei inhomogener Spannungsverteilung die Polarisation ändert und damit die Signalgröße beeinflußt wird.

Die Elastizität des rohrförmigen Ansatzes 3 und des Schrumpfringes 5 sind beim Wandlerelement nach der Erfindung so aufeinander abgestimmt, daß je nach den physikalischen Eigenschaften der verwendeten Materialien an den in Verbindung miteinander stehenden Teilen genügend große Radialkräfte über den gesamten Einsatztemperaturbereich des Wandlerelementes für die Kraftübertragung anliegen. Die Wandstärke W des rohrförmigen Ansatzes 3 ist von besonderer Bedeutung für die Optimierung der Radialspannungsverhältnisse und daher den gewünschten Anforderungen entsprechend zu bemessen. Wesentlich ist auch, daß die Tiefe der Innenbohrung im rohrförmigen Ansatz 3 wenigstens gleich der axialen Länge des Ringscherelementes 4 gewählt wird.

Unter Bezugnahme auf Fig. 1, 2 und 3 besteht das Ringscherelement 4 vorzugsweise aus einem piezoelektrischen Einkristallmaterial. Als piezoelektrische Einkristallmaterialien eignen sich insbesondere Quarz, Turmalin, Lithium-Niobat, Tantäl-Niobat und andere Einkristalle. Die bekannten piezokeramischen Materialien, wie Blei-Metaniobat oder Blei-Zirkonat-Titanat etc., haben gegenüber den vorgenannten Einkristallmaterialien in Temperaturbereichen über 300°C den Nachteil, daß sie ihre Empfindlichkeit und Eigenisolation verlieren sowie die Hysterese zunimmt, wodurch ihre Verwendung nur noch in speziellen Hochfrequenzanwendungen ohne Genauigkeitsansprüche möglich ist. Insbesondere, wenn die keramischen Wandlerelemente in Druck- oder Kraftaufnehmer eingebaut werden sollen, ist eine zuverlässige Kalibrierung der Aufnehmer in höheren Temperaturbereichen praktisch unmöglich.

Für solche Anwendungsfälle sind Einkristallmaterialien daher besser geeignet als piezokeramische. Infolge der kristallinen Struktur und der bereits in der Materie einheitlich bestimmten Kristallachsen entfällt weiter eine künstliche Polarisierung. Dagegen ergibt sich die Notwendigkeit, das Ringscherelement aus einem oder mehreren Kristallblöcken, die zusammengeleimt oder auf andere Weise miteinander verbunden sind, herauszuarbeiten, was anhand von Fig. 3 noch näher erläutert werden soll.

Das einstückige, zusammengeleimte Ringscherelement 4 in Fig. 1 und 2 weist den offenen durchgehenden Längsschlitz S auf und wird auf den rohrförmigen Ansatz 3 am Paßkolben aufgeschoben. Danach wird eine Temperaturdifferenz von etwa 200°C zwischen Ansatz 3 und Schrumpfring 5 vorgesehen, wobei man letzteren bislang direkt auf das Ringscherelement 4 aufgeschoben hatte, um nach Abkühlung eine festmontierte Einheit zu erhalten. Es hat sich jedoch gezeigt, daß insbesondere spröde Einkristalle beim Temperaturausgleichsprozeß, der sofort anschließend erfolgt, Risse bilden, die sich negativ auf die Funktion des Wandlerelementes auswirken, indem sie z. B. bei einem nicht einwandfrei hermetisch abgeschlossenen Aufnehmer zu Isolationsschwierigkeiten führen oder lokale Umpolarisierungen zur Folge haben.

Erfindungsgemäß wird dieser Nachteil durch das Vorsehen eines ebenfalls geschlitzten Montageringes oder Teils 40 beseitigt, der einstückig an einer Montagezange 41, wie schematisch in Fig. 1 angedeutet, ausgebildet ist. Der Montagering 40 klemmt das Ringscherelement 4 auf den rohrförmigen Ansatz 3, wonach der erwähnte Schrumpfring 5 außen auf den Montagering 40 aufgeschoben wird. Der Temperaturausgleich erfolgt nun über den geschlitzten Montagering 40, der als Temperaturschockdämpfer wirkt und nach dem Aufschrumpfvorgang mechanisch von der Montagestange 41 abgetrennt wird, so daß er im Wandlerelement anschließend verbleibt. Der beim Schrumpfvorgang auftretende Wärmestoß gelangt somit nicht in das empfindliche Ringscherelement, sondern wird über den zwischenliegenden Montagering 40 in die Montagezange 41 abgeleitet.

Fig. 2 zeigt das Wandlerelement nach Fig. 1 in geschnittener Ansicht. Das Ringscherelement 4 stellt hier ein Stück aus vier Kreissegmenten dar, die an drei Kittstellen 43, 44, 45 miteinander verbunden sind, während an einer vierten Stelle die Verbindung nicht besteht, sondern diese den Längsschlitz S bildet. Der in dem Montagering 40 vorgesehene Längsschlitz 46 liegt dabei ausgerichtet zu dem Längsschlitz S im Ringschere-ment. Es versteht sich jedoch, daß anstelle des vierteiligen Ringscherelementes auch ein zwei- oder mehrteiliges Kristallstück verwendet werden kann.

Fig. 3 zeigt als Beispiel ein zweiteiliges zusammengekittetes Ringscherelement mit Ein-kristallstruktur, bestehend aus halbschalenför-migen Kristallsegmenten 47, 48 mit den dazu gehörigen Kristallachsen und einer Kittstelle 49 für das Beispiel Turmalin. Auf die Achsorientierung, die jedem Kristallphysiker bekannt ist, soll hier nicht näher eingegangen werden. Von Bedeutung ist lediglich, daß bei Scherbeanspruchung in einer Richtung beide Kristallsegmente auf ihrer Innenfläche dieselbe Ladungspolarität aufweisen. Vom Standpunkt der Signalgröße ist es aber vorteilhafter, ein vierteiliges Ringscherelement gemäß Fig. 2 vorzusehen, da nur ein Teil des Kristallmaterials der halbschalenförmigen Kristallsegmente 47, 48 sich am Schereffekt infolge der orthogonal gerichteten Kristallachsen beteiligt. Obschon das vierteilige Kristallelement teurer ist, wird es daher normalerweise Anwendung finden. Die Herausarbeitung solcher Elemente kann z. B. aus vier zusammengeleimten, entsprechend orientierten Kristallstücken erfolgen, was jedoch nicht weiter gezeigt werden soll, da es jedem Fachmann bekannt ist. Nach Fertigbearbeitung wird eine der Kittstellen mit einem handelsüblichen Lösungsmittel weggelöst, womit wiederum ein einstückiges Ringscherelement mit Längsschlitz und daher der gewünschten radialen Elastizität entsteht. Nach Fertigmontage kann es in vielen Fällen vorteilhaft sein, auch die für die Montage sehr praktischen übrigen Kittstellen wegzulösen. Die Größe der Kittstellen ist für die Erfindung nicht von Bedeutung.

Fig. 4 zeigt eine modifizierte Ausführung eines Wandlerelementes nach der Erfindung zur Verwendung als Beschleunigungsaufnehmer (der Montagering ist hier zur Vereinfachung der Darstellung weggelassen). Die positive und negative Signalableitung erfolgt direkt vom rohrförmigen Ansatz 3 und Schrumpfring 5 des Wandlerelementes vermittels einer auf die freie Stirnfläche des Ansatzes 3 aufgekitteten Printplatte 61. An der Unterseite der Printplatte 61 im Inneren des rohrförmigen Ansatzes 3 ist ein handelsüblicher Impedanzwandler 62 angeordnet, von dem eine Signalleitung 66 zu einem Anschlußstecker führt. An der Oberseite der Printplatte 61 ist innerhalb des nach oben verlängerten Schrumpfringes 5 eine zusätzliche Schwermasse 63 für Justierzwecke eingegossen, vgl. rechte Hälfte von Fig. 4. Die Schwermasse kann aus einer Mischung von Kunstharzkleber und Schwermetallpulver bestehen und hat vorzugsweise ein spezifisches Gewicht von $\delta \approx 14$. Die Justierung des Aufnehmers auf die gewünschte Empfindlichkeit erfolgt durch Ausbohren dieser Schwermasse mit einem passen-den Bohrwerkzeug 65 direkt auf einem Schwing-tisch 60 bis zu einer in Fig. 4 bei 64 angedeuteten Tiefe t. Es läßt sich somit eine sehr genaue und rationelle Justierung der Aufnehmerempfindlichkeit erzielen.

Als Variante kann auch, wie in Fig. 4 in der linken Bildhälfte wiedergegeben, ein Schwerring 67, z. B. aus Schwermetall, am Schrumpfring 5 befestigt oder angelötet sein, der ebenfalls als Justiermasse dient und entsprechend schrittweise bis zur gewünschten Tiefe t ausgebohrt wird. Von Bedeutung ist, daß dieser Justiervor-gang am fertigmontierten Beschleunigungsauf-nehmer durchgeführt werden kann und danach nur noch ein nicht gezeigter Abschlußdeckel über die Anordnung gestülpt zu werden braucht.

## Patentansprüche

1. Verfahren zum Herstellen eines piezoelektrischen Wandlerelementes, insbesondere zum Einbau in Druck-, Kraft- oder Beschleunigungs-aufnehmern, bestehend aus einem Befesti-gungsteil und wenigstens einem durch einen außen umgreifenden Schrumpfring auf das Befestigungsteil aufgeschrumpften Ringscherelement aus piezoelektrischem Material mit einem offen Längsschlitz, dadurch gekennzeichnet, daß das Ringscherelement zunächst mittels eines darum gelegten, ebenfalls geschlitzten Montageringes an dem Befestigungsteil vorfixiert wird und dann in an sich bekannter Weise mittels des außen um den Montagering gelegten, erhitzten Schrumpfringes bei dessen Abkühlung fest auf das Befestigungsteil aufgeschrumpft wird, wobei der Montagering eine Überhitzung des Ringscherelementes beim Schrumpfvorgang verhindert.

2. Verfahren nach Anspruch 1, dadurch gekennzeichnet, daß der geschlitzte Montagering einstückiges Teil einer Montagezange zur direkten Ableitung des beim Schrumpfvorgang auftretenden Wärmestoßes ist, die nach der Abkühlung vom Montagering abgetrennt wird.

3. Verfahren nach Anspruch 1 oder 2, dadurch gekennzeichnet, daß das Ringscherelement aus wenigstens zwei miteinander verkitteten Segmenten aus einem Einkristallmaterial gebildet wird, wobei man eine der Kittstellen unter Schaffung des Längsschlitzes auflöst, und daß der Montagering eine der Anzahl an Segmenten des Ringscherelementes entsprechende Vielzahl an Längsschlitzen hat.

4. Verfahren nach Anspruch 1, 2 oder 3, dadurch gekennzeichnet, daß das Ringscherelement aus Quarz, Turmalin, Lithium-Niobat oder Tantal-Niobat besteht.

5. Verfahren nach Anspruch 1 oder 2, dadurch gekennzeichnet, daß das Ringscherelement aus einer Piezokeramik besteht.

6. Verfahren nach einem der vorhergehenden Ansprüche, dadurch gekennzeichnet, daß in einem durch eine Verlängerung des Schrumpfringes gebildeten Raum oberhalb des Ringscherelementes eine seismische Zusatzmasse vorgesehen wird.

7. Verfahren nach Anspruch 6, dadurch gekennzeichnet, daß die seismische Zusatzmasse eine Mischung aus Schwermetallpulver und Kunstharz ist.

8. Verfahren nach Anspruch 6, dadurch gekennzeichnet, daß die seismische Zusatzmasse ein am Schrumpfring befestigter Metallring ist.

9. Verfahren nach einem der Ansprüche 6 bis 8, dadurch gekennzeichnet, daß die seismische Zusatzmasse schrittweise bis zum Erreichen der Toleranzgrenze der geforderten Empfindlichkeit abgetragen wird.

## Claims

1. Method for the manufacture of a piezoelectric transducer element, particularly for incorporation in pressure, force or acceleration detectors, consisting of a securing part and at least one annular shear element of piezoelectric material with an open longitudinal slot shrunk-fitted on to the securing part by means of an outer surrounding shrink-ring, characterised in that the annular shear element is first assembled on the securing part by means of a likewise slotted setting-up ring encircling the shear element and is then firmly shrunk on to the securing part in known manner by the cooling of the heated shrink-ring positioned externally around the setting-up ring, whereby the setting-up ring prevents overheating of the annular shear element during the shrinking process.

2. Method according to claim 1, characterized in that the slotted setting-up ring is a one-piece part of a setting-up post, for direct conduction away of the heat emission occurring during the shrinking process, and the post is severed from the setting-up ring after the cooling.

3. Method according to claim 1 or 2, characterized in that the annular shear element is formed of at least two segments of a single crystal material bonded together, wherein one of the bonding places is dissolved so as to form the longitudinal slot, and in that the setting-up ring has a plurality of longitudinal slots corresponding to the number of segments of the annular shear element.

4. Method according to claim 1, 2 or 3, characterized in that the annular shear element consists of quartz, tourmaline, lithium niobate or tantalum niobate.

5. Method according to claim 1 or 2, characterized in that the annular shear element consists of a piezoceramic material.

6. Method according to any of the preceding claims, characterized in that a seismic additional mass is provided above the annular shear element in a space formed by an extension of the shrink-ring.

7. Method according to claim 6, characterized in that the seismic additional mass is a mixture of heavy metal powder and plastics material.

8. Method according to claim 6, characterized in that the seismic additional mass is a metal ring secured to the shrink-ring.

9. Method according to any of claims 6 to 8, characterized in that the seismic additional mass is removed stepwise until attaining tolerance limits of the required sensitivity.

## Revendications

1. Procédé de fabrication d'un transducteur piézo-électrique destiné en particulier à un montage dans des capteurs de pressions, de forces ou d'accélérations et se composant d'une pièce de fixation et d'au moins un élément de cisaillement annulaire constitué d'une matière piézo-électrique, emmanché sur la pièce de fixation par une bague de serrage extérieurement enveloppante et muni d'une fente longitudinale ouverte, caractérisé en ce que l'élément de cisaillement annulaire est tout d'abord fixé au préalable sur la pièce de fixation au moyen d'une bague de montage également fendue, disposée tout autour, et est ensuite emmanché solidement sur la pièce de fixation, comme on le sait, à l'aide de la bague de serrage chauffée, disposée extérieurement à la bague de montage, et ce, lors du refroidissement de ladite bague de serrage, la bague de montage empêchant une surchauffe de l'élément de cisaillement annulaire au cours de l'emmanchement.

2. Procédé selon la revendication 1, caractérisé en ce que la bague de montage fendue forme partie intégrante d'une pince de montage pour la dérivation directe du choc thermique engendré au cours de l'emmanchement, la pince de montage étant séparée de la bague de montage après le refroidissement.

3. Procédé selon l'une quelconque des revendications 1 et 2, caractérisé en ce que l'élément de cisaillement annulaire est formé d'au moins deux segments mastiqués l'un à l'autre et composés d'une matière monocristalline, l'un des endroits de masticage étant dissous pour la création d'une fente longitudinale; et en ce que la bague de montage a un nombre de fentes longitudinales correspondant au nombre de segments de l'élément de cisaillement annulaire.

4. Procédé selon l'une quelconque des revendications 1 à 3, caractérisé en ce que l'élément de cisaillement annulaire se compose de quartz, de tourmaline, de niobate de lithium ou de niobate de tantale.

5. Procédé selon l'une quelconque des revendications 1 et 2, caractérisé en ce que l'élément de cisaillement annulaire se compose d'une piézocéramique.

6. Procédé selon l'une quelconque des revendications 1 à 5, caractérisé en ce qu'une masse d'addition sismique est prévue au-dessus de l'élément de cisaillement annulaire dans un espace formé par un prolongement de la bague de serrage.

7. Procédé selon la revendication 6, caractérisé en ce que la masse d'addition sismique est un mélange de résine synthétique et de métal lourd en poudre.

8. Procédé selon la revendication 6, caractérisé en ce que la masse d'addition sismique est une bague métallique fixée sur la bague de serrage.

9. Procédé selon l'une quelconque des revendications 6 à 8, caractérisé en ce que la masse d'addition sismique est évidée graduellement jusqu'à ce que soit atteinte la limite de tolérance de la sensibilité exigée.

0 014 744

Fig 1

Fig 2

Fig 3

Fig 4